(19) Europäisches Patentamt
European Patent Office
Office européen des brevets

(11) **EP 2 861 420 B1**

(12) **FASCICULE DE BREVET EUROPEEN**

(45) Date de publication et mention
de la délivrance du brevet:
**11.10.2017 Bulletin 2017/41**

(21) Numéro de dépôt: **13728724.9**

(22) Date de dépôt: **12.06.2013**

(51) Int Cl.:
**B32B 17/10** *(2006.01)*          **B60J 7/00** *(2006.01)*

(86) Numéro de dépôt international:
**PCT/EP2013/062095**

(87) Numéro de publication internationale:
**WO 2013/189790 (27.12.2013 Gazette 2013/52)**

(54) **TOIT VITRÉ DE VÉHICULE AUTOMOBILE**

GLASDACH FÜR EIN KRAFTFAHRZEUG

SUNROOF FOR A MOTOR VEHICLE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.06.2012 BE 201200413**

(43) Date de publication de la demande:
**22.04.2015 Bulletin 2015/17**

(73) Titulaire: **AGC Glass Europe
1348 Louvain-La-Neuve (BE)**

(72) Inventeur: **LEGRAND, Denis
F-59144 Wargnies Le Grand (FR)**

(74) Mandataire: **Chabou, Samia
AGC Glass Europe
Technovation Centre
IP Department
Rue Louis Blériot, 12
6041 Gosselies (BE)**

(56) Documents cités:
**EP-A1- 0 418 123          EP-A2- 0 908 302
WO-A1-01/02167          WO-A1-2005/115747
WO-A1-2007/077460          WO-A1-2007/093828
BE-A4- 1 013 036          FR-A1- 2 775 282**

**Description**

L'invention concerne les toits de véhicules constitués au moins en partie d'un vitrage feuilleté.

La mise en oeuvre de vitrages de toits feuilletés a été proposée antérieurement en particulier pour conférer à ces toits des propriétés optiques particulières. A titre indicatif des toits de ce type visant des propriétés colorimétriques sont présentés dans le brevet EP 1 200 256 B.

Hors les propriétés optiques, les toits doivent aussi présenter des caractéristiques mécaniques qui les apparentent à celles des toits métalliques traditionnels. Dans ce sens le document précité propose en particulier le choix de feuilletés comprenant des feuilles trempées ou semi-trempées. Ces toits renforcent la rigidité sans risque de rupture sous les efforts auxquels ils sont soumis.

Les feuilles de verre trempées ou semi-trempées conservent ordinairement des traces de ces traitements. Dans leur manipulation les verres portés à température élevée, supérieure à 600°C, sont refroidis d'autant plus rapidement que la trempe doit être plus intense. De même la trempe doit être d'autant plus intense que la feuille de verre est plus mince afin de créer le gradient de température nécessaire pour créer les contraintes entre la surface de la feuille et le coeur de celle-ci.

Les techniques de trempe les plus usuelles comportent le soufflage d'air à température ambiante à partir d'une multiplicité de buses. L'impact des jets d'air sur la feuille de verre ne peut faire abstraction d'une certaine localisation sur cette feuille. Le résultat de cette distribution des impacts est l'apparition de ce qui est désigné sous le nom de « fleur de trempe ». Ces marques, qui n'introduisent pas normalement de défauts optiques en transmission, sont néanmoins perceptibles en réflexion sous forme d'irisations bien visibles sous certaines incidences d'observation. La vision des toits depuis l'extérieur est normalement sous des angles d'incidence réduits qui font clairement apparaître ces fleurs de trempe.

L'opération de trempe est aussi souvent conduite en faisant passer la feuille préalablement formée sur une série de rouleaux convoyeurs. L'air de refroidissement est soufflé sur la feuille pendant ce transport. Dans ce cas la feuille de verre conserve souvent la trace du contact avec les rouleaux.

Pour éviter ce que les constructeurs considèrent comme préjudiciable à l'esthétique l'invention propose des toits feuilletés dont la feuille de verre tournée vers l'extérieur du véhicule n'a pas subi de trempe. Autrement dit les feuilles correspondantes sont simplement recuites (annealed). Les feuilles en question, après les traitements thermiques de mise en forme, sont refroidies lentement de telle sorte que la différence de température entre la surface de la feuille et le coeur de celle-ci reste relativement faible et que les contraintes d'origine thermique sont également limitées.

Dans la formation des feuilles entrant dans la composition des toits, celles-ci sont normalement légèrement bombées. C'est donc en sortant de l'opération de bombage que s'opère le refroidissement. Dans la pratique le refroidissement de la feuille peut être accéléré comme indiqué ci-dessus pour créer les contraintes. A l'inverse si l'on veut éviter ou limiter les contraintes, le refroidissement est juste maintenu en sorte que la pièce ne se déforme plus, ce qui le plus souvent consiste à la laisser au contact de l'air ambiant sans convection forcée.

Comme rappelé ci-dessus, dans l'art antérieur le choix de feuilles trempées dans des vitrages feuilletés a pour but de conférer la rigidité et plus encore la résistance aux efforts en flexion. Il est proposé selon l'invention de conserver cette propriété en associant à la feuille de verre durcie disposée vers l'extérieur, une feuille de verre trempée tournée vers l'habitacle.

Les vitrages de toit sont ordinairement collés à la structure du véhicule pour pouvoir être montés « flush », autrement dit dans le prolongement des pièces de carrosserie voisines, sans décrochement. Le collage est réalisé sur la feuille interne. C'est elle qui en premier doit supporter les efforts. Le choix de l'utilisation d'une feuille trempée est en conséquence préférable.

Une exigence des constructeurs rappelée dans la demande précitée, est aussi d'alléger les véhicules. L'utilisation de toits vitrés à la place de toits métalliques conduit à une surcharge qu'il est nécessaire de limiter autant que possible. Pour cette raison l'épaisseur du vitrage feuilleté doit être aussi maintenue aussi faible que le permet la conservation des propriétés mécaniques nécessaires dont il est question ci-dessus.

Le plus usuellement dans les réalisations antérieures, les feuilles utilisées pour les toits feuilletés sont d'épaisseurs identiques. La mise en forme des feuilles en est facilitée. Le bombage peut être réalisé dans une seule opération les deux feuilles étant superposées pour assurer un bon appariement. Cette formation peut aussi s'achever par la trempe qui concerne alors les deux feuilles.

Pour les raisons exposées ci-dessus, si les deux feuilles de verre doivent être de même forme pour conduire à un assemblage sans défaut, en revanche leur rôle respectif fait qu'elles peuvent être différentes. En particulier pour une épaisseur totale déterminée, les deux feuilles sont avantageusement d'épaisseur différente. Selon l'invention la feuille qui est disposée vers l'intérieur, feuille qui étant en liaison avec la structure du véhicule doit supporter directement les contraintes, est de préférence la plus épaisse des deux.

Etant donné que l'épaisseur totale doit rester limitée, l'accroissement de l'épaisseur de la feuille interne trempée ou semi trempée, conduit à une réduction de l'épaisseur de la feuille externe. Cette disposition peut paraître paradoxale dans la mesure où les aléas extérieurs, projections de gravillons notamment, pourraient conduire, pour des raisons de résistance à ces impacts, à favoriser une feuille externe plus épaisse. Néanmoins il est apparu à l'expérience que le risque de rupture provoqué par l'impact est sensiblement moindre sur les toits en comparaison de ce que l'on constate par exemple sur les pare-brise en raison même de la position de ces vitrages. Par suite une épaisseur moindre de la feuille externe n'est pas préjudiciable.

Par ailleurs la différence de résistance à l'impact, entre verre recuit et trempé n'est pas très significative, de telle sorte que le choix d'une feuille recuite n'est pas non plus contrindiqué.

Des spécificités de l'invention exposées précédemment il résulte que les feuilles entrant dans la constitution des vitrages selon l'invention sont mises en forme séparément. Ce mode ordinairement n'est pas préféré en raison des petites différences de forme qui peuvent apparaître. Dans le cas de l'invention, le fait d'associer deux feuilles d'épaisseurs différentes, dont l'une est relativement faible, permet un assemblage qui présente un risque minimum de délamination. Des écarts limités de conformation sont plus facilement compensés à l'assemblage, la feuille la moins épaisse étant conduite à épouser la forme de la feuille la plus épaisse sous des efforts très limités.

Les vitrages selon l'invention servant de toit automobile présentent avantageusement une épaisseur totale de verre qui n'est pas supérieure à 5mm, et de préférence qui n'est pas supérieure à 4,5mm et dans lequel le rapport des épaisseurs des feuilles recuite et trempée, n'est pas supérieur à 0,8 et de préférence pas supérieur à 0,6.

Cette épaisseur peut être d'autant plus limitée que les dimensions du vitrage sont plus petites. Pour des vitrages de 1m$^2$ ou plus, on préfère conserver une épaisseur qui n'est pas inférieure à 3,5mm.

La feuille externe, même d'épaisseur limitée, est de préférence d'au moins 1mm et n'est pas supérieure à 2,2mm. Son épaisseur est de préférence comprise entre 1,2 et 1,8mm.

La feuille interne nécessairement plus épaisse est d'au moins 1,9mm et au plus de 3,5mm et de préférence comprise entre 2 et 3mm.

Le rapport entre les épaisseurs des feuilles externes et internes n'est pas supérieur à 0,8 et de préférence pas supérieur à 0,6. Il peut être aussi faible que 0,3.

Les feuilles de verre trempées utilisées selon l'invention sont telles qu'elles répondent aux exigences de la norme ECE R$_{43}$. En d'autres termes, les feuilles de verre trempées lorsqu'elles se brisent dans les conditions de la norme, conduisent à un nombre déterminé de fragments de dimensions et formes également déterminées.

L'intensité de la trempe conduisant à ces propriétés, est fonction de l'épaisseur des feuilles considérées. Il s'agit en effet de faire en sorte que les contraintes de surface atteignent une certaine intensité. Celles-ci dépendent de la vitesse de refroidissement imposée en surface par rapport au refroidissement subi au coeur de la feuille. Moins la feuille est épaisse, plus le déséquilibre de température est difficile à obtenir. Le choix selon l'invention de la feuille la trempée la plus épaisse, ne soulève pas de difficultés particulières à ce sujet. En pratique les opérations de trempe sont réglées de telle sorte que pour des feuilles dont les épaisseurs répondent aux conditions énoncées précédemment, la contrainte centrale de surface ne soit pas inférieure à 30MPa et de préférence pas inférieure à 50MPa et peut dépasser 60MPa.

Les feuilles de verre qui n'ont pas subi de trempe ont par comparaison des niveaux de contraintes très réduits. Pour ces feuilles de verre les contraintes centrales de surface ne dépassent pas de préférence 10MPa et avantageusement pas 5MPa.

Comme indiqué précédemment le fait d'avoir une feuille relativement mince non-trempée à l'extérieur est d'autant préférable que la trempe est plus difficile pour les verres peu épais. Pour ces verres, après formage, le refroidissement se fait au contact simplement de l'air ambiant.

Les feuilles de verre sont assemblées de manière traditionnelle au moyen d'intercalaires de matériau thermoplastique. Il s'agit le plus usuellement de feuilles de polyvinyl-butyral (PVB), mais d'autres matériaux, notamment les copolymères d'éthylène vinyl-acétate (EVA) ou les chlorures de polyvinyl (PVC) peuvent aussi être choisis. Les épaisseurs de ces intercalaires sont traditionnellement de l'ordre de 0,3 à 1,5mm. Pour les feuilles de PVB les épaisseurs commerciales usuelles sont de 0,38mm et 0,76mm.

Comme pour les pare-brise, la feuille intercalaire garantit le maintien en place des fragments des feuilles de verre en cas de rupture. L'épaisseur choisie pour l'intercalaire garantit aussi une résistance à l'éviction en cas d'accident. L'incidence de l'intercalaire sur le poids du vitrage est bien moindre que celle de l'épaisseur des feuilles de verre. Aussi le choix de l'épaisseur est d'abord commandé par les considérations indiquées ci-dessus.

Il va de soi que les toits selon l'invention présentent des propriétés optiques telles que celles décrites dans le brevet précité. Leur transmission lumineuse (TL), leur transmission énergétique (TE), leur sélectivité (TL/FS, FS facteur solaire est la somme de la transmission énergétique directe et de celle résultant de réémission vers l'intérieur après absorption par le verre) de même que leur couleur en transmission et en réflexion doivent satisfaire aux multiples exigences des constructeurs dans ce domaine. Pour répondre à celles-ci, le choix de verres de couleur peut être nécessaire. L'obtention de la coloration peut aussi résulter de l'utilisation d'intercalaires de couleur associés à des verres clairs ou de couleurs.

Pour les constructeurs automobile, le choix de la coloration est très largement orienté vers les couleurs dites « neutres », notamment pour les couleurs en réflexion qui doivent s'harmoniser avec les couleurs de carrosserie. Les couleurs neutres sont généralement grises ou légèrement bleutées. Les couleurs pourpres sont à l'inverse à éviter.

Dans les systèmes colorimétriques le plus utilisé est celui du Comité Internationale de l'Eclairage (CIE). Les couleurs sont définies notamment dans le système dit CIEL*a*b* et sont mesurées sous l'Illuminant D65/10°. Pour répondre aux choix indiqué ci-dessus, les vitrages selon l'invention présentent avantageusement réflexion les valeurs de coordonnées :

$$-4 < a^* < 0 \text{ et } -3 < b^* < 0$$

De même selon l'invention, les coordonnés colorimétriques en transmission sont avantageusement telles que :

$$-4 < a^* < 0 \text{ et } -4 < b^* < 0.$$

La présence de larges surfaces vitrées dans les toits des véhicules requiert une attention particulière en ce qui concerne le confort thermique. Il faut éviter notamment que ces toits conduisent à un effet de serre lors de l'exposition au rayonnement solaire. De manière connue, en dehors du contrôle résultant de l'utilisation de verres de couleurs absorbant une part du rayonnement, les vitrages en question peuvent comporter des systèmes de couches minces réfléchissant sélectivement les infrarouges.

Pour maintenir un certain confort thermique, il est préférable que la transmission énergétique ne dépasse pas 25% de l'énergie du rayonnement incident, et de préférence soit au plus égale à 15%. Dans la mise en oeuvre des vitrages il faut tenir compte du fait qu'une part importante de l'énergie transmise l'est par le rayonnement visible. Pour cette raison le contrôle de la transmission énergétique conduit à limiter aussi la transmission dans le visible. En pratique la transmission lumineuse visible, TL, pour les toits en question n'est pas supérieure à 50%, et le plus habituellement ne dépasse pas 35%.

Le contrôle de la transmission lumineuse est obtenu en premier par le choix de verres de couleur et le cas échéant d'intercalaire également de couleur.

Les toits des véhicules automobile doivent aussi le cas échéant remplir d'autres fonctions, ou permettre d'adapter leur fonction selon les conditions d'utilisation. Très régulièrement il est proposé de profiter du toit d'un véhicule et de son exposition au rayonnement solaire pour y installer des générateurs photovoltaïques qui contribuent à la production du courant électrique nécessaire au fonctionnement des différents organes et appareils embarqués dans le véhicule.

La présence de cellules photovoltaïques incorporées au toit est bien entendu compatible avec les dispositions de l'invention. Les cellules traditionnellement sont disposées entre les feuilles de verre, et sont dans le matériau intercalaire formé d'une ou plusieurs feuilles dans, ou entre lesquelles, les cellules sont disposées.

Si le toit comporte des cellules photovoltaïques il est préférable que la feuille de verre externe soit aussi transparente que possible aux UV. On utilise avantageusement pour cette feuille un verre clair ou même extra-clair. Le fait de limiter l'épaisseur de la feuille externe constitue aussi un avantage dans la mesure où l'absorption en est plus limitée.

D'autres dispositifs sont encore éventuellement inclus dans les toits de verre feuilletés. Des ensembles d'éclairage de l'habitacle sont ainsi régulièrement proposés. De tels ensembles sont constitués par exemple de séries de LEDs. Ces ensembles, comme les cellules photovoltaïques, sont introduits dans, ou entre des feuilles intercalaires, et sont alimentés par un circuit électrique ordinairement constitué par un motif approprié réalisé dans des couches minces conductrices et transparentes.

Les toits peuvent encore comporter des ensembles qui permettent de commander des fonctions telles que le changement de transmission lumineuse. Il s'agit par exemple d'ensembles électro-chromes qui par un changement de nature chimique des éléments qu'ils renferment, s'obscurcissent et s'éclaircissent sous l'effet d'un champ électrique. Il s'agit aussi éventuellement de composés qui modifient la transmission lumineuse, non pas par modification chimique, mais en jouant de propriétés d'orientation de particules sous l'effet également d'un champ électrique tels que les dispositifs dits SPD (« suspended particles devices »). Le mode d'insertion de tels dispositifs est décrit par exemple dans la publication WO 2005/102688.

L'invention est décrite de manière détaillée en faisant référence à la planche de dessins dans laquelle :

- la figure 1 représente en coupe schématique un vitrage de toit selon l'invention

- la figure 2 est analogue à la précédente, le vitrage comportant des moyens pour modifier ses propriétés opto-énergétiques

- la figure 3 est analogue aux précédentes, le vitrage comportant cette fois des éléments fonctionnels supplémentaires introduits entre les deux feuilles de verre.

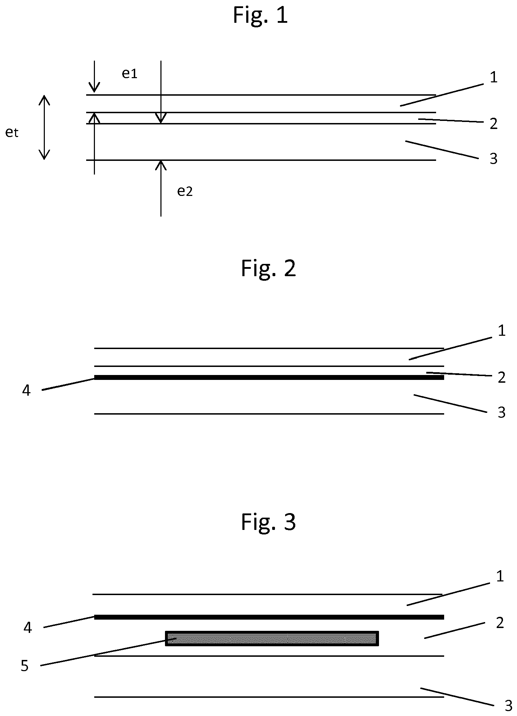

La figure 1 montre un ensemble feuilleté comprenant deux feuilles de verre 1 et 2. La feuille de verre 1 est destinée à être exposée à l'extérieur. Cette feuille est d'épaisseur $e_1$. Une deuxième feuille de verre 3 tournée vers l'intérieur du véhicule est d'épaisseur $e_2$ sensiblement plus grande que $e_1$. Les deux feuilles sont assemblées de manière traditionnelle au moyen d'un intercalaire 3 composé d'une feuille thermoplastique, le plus fréquemment une feuille de PVB ou d'EVA.

La feuille de verre 3, qui est fixée à la structure du véhicule est en verre trempé. La feuille de verre 1 tournée vers l'extérieur est recuite.

Le vitrage étant destiné à entrer dans la composition d'un toit, il présente normalement des caractéristiques optiques et énergétiques en rapport avec cet usage. Une constante dans cette utilisation est la nécessité de contrôler l'échauffement du véhicule lorsqu'il est exposé au rayonnement solaire. A cet effet le toit doit faire office de filtre notamment pour les rayonnements infrarouges, mais aussi pour une part significative des rayonnements visibles. Pour ces raisons les vitrages sont avantageusement de couleur. Dans les ensembles feuilletés de préférence au moins une des feuilles de verre est de couleur.

Pour assurer le contrôle thermique le vitrage comprend souvent un système qui réfléchit sélectivement les infrarouges. Il s'agit notamment de couches minces appliquées sur les feuilles de verre ou sur un film support qui s'ajoute à l'intercalaire et est compris dans celui-ci.

A la figure 2 est représenté un vitrage comportant un système de couches minces 4, appliqué sur la feuille de verre 3. Les systèmes de couches traditionnellement utilisés dans ces feuilletés sont notamment ceux comportant une ou plusieurs couches métalliques, notamment à base d'argent, associées à des couches diélectriques qui protègent les couches métalliques et permettent de sélectionner les rayonnements réfléchis de telle sorte que les vitrages ne présentent pas, surtout en réflexion, des colorations indésirables. La présence entre les feuilles de verre garantit ces systèmes de couches contre les aléas chimiques ou mécaniques extérieurs. Les systèmes en conséquence peuvent être constitués avec des couches qualifiées habituellement de « tendres », couches formées notamment par pulvérisation cathodique. Si les couches minces métalliques sont les filtres infrarouge les plus efficaces, il est possible aussi d'utiliser des couches constituées d'oxydes du type oxyde d'étain dopé. L'avantage de ces couches est qu'elles peuvent être formées dans des conditions économiques avantageuses, par exemple par pyrolyse gazeuse directement sur le ruban de verre sortant du « float ». Il est encore possible d'utiliser des intercalaires comportant des particules absorbant les infrarouges, notamment des particules noyées dans le matériau intercalaire. De façon connue des particules d'ITO (indium tin oxide) sont mises en oeuvre pour ces applications.

Les vitrages constituant les toits des véhicules sont choisis de manière avantageuse pour que leur transmission énergétique TE ne soit pas supérieure à 25% de l'énergie du rayonnement incident. De préférence cette transmission est aussi limitée que possible. En combinant la coloration des feuilles de verre pour leur conférer une absorption significative, avec avantageusement des couches réfléchissantes, la transmission énergétique peut être réduite par exemple à 10% et moins. Cette transmission est d'autant plus réduite que la transmission des rayons visibles est elle-même plus réduite.

A la figure 2 le système de couches 4 est présenté sur la feuille de verre 3. Cette disposition est préférable lorsque notamment des cellules photovoltaïques sont insérées entre les deux feuilles de verre et qu'il est préférable que le rayonnement transmis jusqu'à ces cellules soit aussi intense que possible. Pour d'autres applications, comme celle représentée à la figure 3, le système de couches est à l'inverse disposé sur la feuille 1.

Le mode représenté à la figure 3 est par exemple celui correspondant à l'insertion dans le vitrage d'éléments fonctionnels 5 dont l'exposition prolongée au rayonnement infrarouge peut entraîner une altération. Un cas typique est constitué par les films SPD modifiant la transmission lumineuse de manière commandée. La nature des particules en suspension dont l'orientation permet de modifier la transmission, les rends particulièrement sensibles à la chaleur. Il est donc nécessaire de réduire le plus possible les infrarouges auxquels ces films sont exposés. Pour obtenir ce résultat la feuille de verre 1 peut être de couleur et fortement absorbante, mais ceci conduit à une limitation importante de la transmission lumineuse disponible dans l'habitacle le film SPD réduisant lui-même la transmission même dans l'état « clair », favorable à cette transmission. Le choix d'une protection des infrarouges par le biais d'un système de couches sélectif performant permet de conserver une transmission lumineuse plus importante.

Le choix du système de couches est avantageusement celui de systèmes à plusieurs couches d'argent pour obtenir un filtre efficace et qui permette le contrôle de la coloration notamment en réflexion. Un ensemble de couches particulièrement efficace est tel que décrit dans la demande WO2011/147875. Dans cette demande le système préconisé comporte trois couches d'argent et des couches diélectriques, l'ensemble étant choisi, notamment les épaisseurs des couches d'argent, de telle sorte que la coloration en réflexion soit satisfaisante même sous de faibles incidences d'observation.

**Revendications**

**1.** Toit de véhicule automobile comprenant deux feuilles de verre (1,3) réunies au moyen d'un intercalaire thermoplastique (2), dont la feuille (1) tournée vers l'extérieur est recuite, et la feuille (3) tournée vers l'intérieur, est en verre trempé, l'épaisseur totale des feuilles de verre n'étant pas supérieure à 5mm et de préférence pas supérieure à 4,5mm et dans lequel le rapport des épaisseurs des feuilles recuite et trempée, n'est pas supérieur à 0,8 et de préférence pas supérieur à 0,6.

**2.** Toit selon la revendication 1 dans lequel l'épaisseur de la feuille de verre recuit (1) est d'au moins 1mm et n'est pas supérieure à 2,2mm, et de préférence comprise entre 1,2 et 1,8mm.

**3.** Toit selon l'une des revendications précédentes dans lequel l'épaisseur de la feuille de verre trempée (3) est d'au moins 1,9mm et au plus de 3,5mm, et de préférence comprise entre 2 et 3mm.

4. Toit selon l'une des revendications précédentes dans lequel la contrainte centrale de surface de la feuille trempée (3) n'est pas inférieure à 30MPa et de préférence n'est pas inférieure à 50MPa.

5. Toit selon l'une des revendications précédentes dans lequel la feuille recuite (1) présente une contrainte centrale de surface qui n'est pas supérieure à 10MPa et de préférence pas supérieure à 5MPa.

6. Toit selon l'une des revendications précédentes comprenant au moins une feuille de verre de couleur.

7. Toit selon l'une des revendications précédentes dans lequel la transmission énergétique est limitée par la présence d'un ensemble de couches minces réfléchissant sélectivement une part du rayonnement infrarouge incident telle qu'en combinaison avec l'énergie absorbée par les feuilles de verre, la transmission énergétique demeure au plus égale à 25% et de préférence inférieure à 15%.

8. Toit selon la revendication 7 dans lequel l'ensemble des couches minces est supporté par un film transparent introduit entre les deux feuilles de verre.

9. Toit selon l'une des revendications 1 à 7 dans lequel l'intercalaire thermoplastique comprend des particules d'oxydes absorbant les infrarouges, et de préférence de particules d'ITO (indium-tin-oxide).

10. Toit selon l'une des revendications précédentes comprenant inclus dans l'intercalaire un ensemble de cellules photovoltaïques et leurs conducteurs associés, la feuille recuite 1 étant de verre clair ou de verre extra-clair.

11. Toit selon la revendication 10 et l'une des revendications 8 et 9, dans lequel le système de couches réfléchissant les infrarouges est situé sous les cellules photovoltaïques par rapport au cheminement du rayonnement solaire incident.

12. Toit selon l'une des revendications 1 à 7 et l'une des revendications 8 et 9, comprenant incluses dans l'intercalaire, un film SPD et les conducteurs associés, commandant la modification de la transmission lumineuse, l'ensemble des couches réfléchissant sélectivement les infrarouges étant disposé au-dessus du film SPD par rapport au cheminement du rayonnement solaire incident.

13. Toit selon la revendication 12 dans lequel l'ensemble des couches réfléchissant les infrarouges comporte une pluralité de couches minces d'argent séparées par des couches diélectriques.

14. Toit selon la revendication précédente dans lequel l'ensemble réfléchissant les infrarouges comporte trois couches d'argent.

15. Toit selon l'une des revendications précédentes dans lequel la réflexion lumineuse présente les coordonnées colorimétriques dans le système CIE L*a*b* telles que :

$$-4 < a* < 0 \text{ et } -3 < b* < 0$$

16. Toit selon l'une des revendications précédentes dans lequel la transmission lumineuse présente les coordonnées colorimétriques dans le système CIE L*a*b* telles que :

$$-4 < a* < 0 \text{ et } -4 < b* < 0.$$

**Patentansprüche**

1. Kraftfahrzeugdach, welches zwei Glasscheiben (1, 3) umfasst, die mittels einer thermoplastischen Zwischenlage (2) vereinigt sind, wobei die nach außen gewandte Scheibe (1) getempert ist und die nach innen gewandte Scheibe (3) aus vorgespanntem Glas besteht, wobei die Gesamtdicke der Glasscheiben nicht größer als 5 mm und vorzugsweise nicht größer als 4,5 mm ist und wobei das Verhältnis der Dicken der getemperten und der vorgespannten Scheibe nicht größer als 0,8 und vorzugsweise nicht größer als 0,6 ist.

2. Dach nach Anspruch 1, wobei die Dicke der Scheibe aus getempertem Glas (1) wenigstens 1 mm beträgt und nicht größer als 2,2 mm ist und vorzugsweise zwischen 1,2 und 1,8 mm liegt.

3. Dach nach einem der vorhergehenden Ansprüche, wobei die Dicke der vorgespannten Glasscheibe (3) wenigstens 1,9 mm und höchstens 3,5 mm beträgt und vorzugsweise zwischen 2 und 3 mm liegt.

4. Dach nach einem der vorhergehenden Ansprüche, wobei die zentrale Oberflächenspannung der vorgespannten Scheibe (3) nicht kleiner als 30 MPa und vorzugsweise nicht kleiner als 50 MPa ist.

5. Dach nach einem der vorhergehenden Ansprüche, wobei die getemperte Scheibe (1) eine zentrale Oberflächenspannung aufweist, welche nicht größer als 10 MPa und vorzugsweise nicht größer als 5 MPa ist.

6. Dach nach einem der vorhergehenden Ansprüche, welches wenigstens eine farbige Glasscheibe umfasst.

7. Dach nach einem der vorhergehenden Ansprüche, wobei die Energieübertragung durch das Vorhandensein einer Anordnung dünner Schichten begrenzt wird, die selektiv einen solchen Teil der einfallenden Infrarotstrahlung reflektieren, dass in Kombination mit der von den Glasscheiben absorbierten Energie die Energieübertragung höchstens 25 % beträgt und vorzugsweise kleiner als 15 % bleibt.

8. Dach nach Anspruch 7, wobei die Anordnung der dünnen Schichten von einer durchsichtigen Folie getragen wird, die zwischen die beiden Glasscheiben eingeführt ist.

9. Dach nach einem der Ansprüche 1 bis 7, wobei die thermoplastische Zwischenlage Oxidpartikel umfasst, welche die Infrarotstrahlung absorbieren, und vorzugsweise ITO-Partikel (Indiumzinnoxid).

10. Dach nach einem der vorhergehenden Ansprüche, welches, in die Zwischenlage eingebettet, eine Anordnung von Solarzellen und ihre zugeordneten Leiter umfasst, wobei die getemperte Scheibe (1) aus Klarglas oder aus extra klarem Glas besteht.

11. Dach nach Anspruch 10 und einem der Ansprüche 8 und 9, wobei sich das System von Schichten, welche die Infrarotstrahlung reflektieren, bezogen auf den Weg der einfallenden Sonnenstrahlung unter den Solarzellen befindet.

12. Dach nach einem der Ansprüche 1 bis 7 und einem der Ansprüche 8 und 9, welches, in die Zwischenlage eingebettet, eine SPD-Folie und die zugeordneten Leiter umfasst, welche die Modifikation der Lichtdurchlässigkeit steuert, wobei sich die Anordnung der Schichten, die selektiv die Infrarotstrahlung reflektieren, bezogen auf den Weg der einfallenden Sonnenstrahlung oberhalb der SPD-Folie befindet.

13. Dach nach Anspruch 12, wobei die Anordnung der Schichten, welche die Infrarotstrahlung reflektieren, mehrere dünne Silberschichten umfasst, die durch dielektrische Schichten getrennt sind.

14. Dach nach dem vorhergehenden Anspruch, wobei die Anordnung, welche die Infrarotstrahlung reflektiert, drei Silberschichten umfasst.

15. Dach nach einem der vorhergehenden Ansprüche, wobei die Lichtreflexion solche kolorimetrischen Koordinaten im CIE-System L*a*b* aufweist, dass gilt:

$$-4 < a^* < 0 \text{ und } -3 < b^* < 0.$$

16. Dach nach einem der vorhergehenden Ansprüche, wobei die Lichtdurchlässigkeit solche kolorimetrischen Koordinaten im CIE-System L*a*b* aufweist, dass gilt:

$$-4 < a^* < 0 \text{ und } -4 < b^* < 0.$$

**Claims**

1. Motor vehicle roof comprising two glass sheets (1, 3) joined by means of a thermoplastic interlayer (2), of which the sheet (1) turned toward the outside is annealed, and the sheet (3) turned toward the inside is made of toughened glass, the total thickness of the glass sheets not being greater than 5 mm and preferably not greater than 4.5 mm and wherein the ratio of the thicknesses of the annealed and toughened sheets is not greater than 0.8 and preferably is not greater than 0.6.

2. Roof according to Claim 1, wherein the thickness of the annealed glass sheet (1) is at least 1 mm and is not greater than 2.2 mm, and preferably is between 1.2 and 1.8 mm.

3. Roof according to either of the preceding claims, wherein the thickness of the toughened glass sheet (3) is at least 1.9 mm and at most 3.5 mm, and preferably is between 2 and 3 mm.

4. Roof according to one of the preceding claims, wherein the central surface stress of the toughened sheet (3) is not less than 30 MPa and preferably is not less than 50 MPa.

5. Roof according to one of the preceding claims, wherein the annealed sheet (1) has a central surface stress which is not greater than 10 MPa and preferably is not greater than 5 MPa.

6. Roof according to one of the preceding claims, comprising at least one colored glass sheet.

7. Roof according to one of the preceding claims, wherein the energy transmission is limited by the presence of a set of thin layers selectively reflecting a portion of the incident infrared radiation such that, in combination with the energy absorbed by the glass sheets, the energy transmission remains at most equal to 25% and preferably less than 15%.

8. Roof according to Claim 7, wherein the set of thin layers is supported by a transparent film introduced between the two glass sheets.

9. Roof according to one of Claims 1 to 7, wherein the thermoplastic interlayer comprises oxide particles that absorb the infrared rays, and preferably ITO (indium tin oxide) particles.

10. Roof according to one of the preceding claims, comprising, included in the interlayer, a set of photovoltaic cells and their associated conductors, the annealed sheet 1 being made of clear glass or of extraclear glass.

11. Roof according to Claim 10 and either of Claims 8 and 9, wherein the system of layers reflecting the infrared rays is located under the photovoltaic cells with respect to the path of the incident solar radiation.

12. Roof according to one of Claims 1 to 7 and either of Claims 8 and 9, comprising, included in the interlayer, an SPD film and the associated conductors, controlling the modification of the light transmission, the set of layers selectively reflecting the infrared rays being positioned above the SPD film with respect to the path of the incident solar radiation.

13. Roof according to Claim 12, wherein the set of layers reflecting the infrared rays comprises a plurality of thin silver layers separated by dielectric layers.

14. Roof according to the preceding claim, wherein the set reflecting the infrared rays comprises three silver layers.

15. Roof according to one of the preceding claims, wherein the light reflection has the colorimetric coordinates in the CIE L*a*b* system such that:

$$-4 < a^* < 0 \text{ and } -3 < b^* < 0.$$

16. Roof according to one of the preceding claims, wherein the light transmission has the colorimetric coordinates in the CIE L*a*b* system such that:

$$-4 < a^* < 0 \text{ and } -4 < b^* < 0.$$

## Fig. 1

et

e1

e2

1

2

3

## Fig. 2

1

2

4

3

## Fig. 3

1

4

5

2

3

EP 2 861 420 B1

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1200256 B
- WO 2005102688 A
- WO 2011147875 A